# EUROPEAN PATENT APPLICATION

(11) **EP 4 797 481 A1**
(43) Date of publication of application: **26.08.2026**
(21) Application number: 26158461.9
(22) Date of filing: 13.02.2026
(51) Int. Cl.: H02J 3/28, H02J 3/38, H02J 3/388

(54) **PHOTOVOLTAIC POWER GENERATION SYSTEM, AND MISCONNECTION DETECTION METHOD AND PHASE SEQUENCE DETECTION METHOD THEREFOR**

(30) Priority: 22.02.2025 CN 202510201479
(71) Applicant: Huawei Technologies Co., Ltd., Shenzhen, Guangdong 518129 (CN)
(72) Inventor: ZHANG, Peng, Shenzhen 518129 (CN); QIU, Tao, Shenzhen 518129 (CN); WEN, Jun, Shenzhen 518129 (CN); LIU, Wentao, Shenzhen 518129 (CN); LIU, Xiaoxia, Shenzhen 518129 (CN)
(74) Representative: Gill Jennings & Every LLP

(57) **Abstract**

Embodiments of this application disclose a photovoltaic power generation system, and a misconnection detection method and a phase sequence detection method therefor, and relate to the field of energy technologies, to resolve a problem of how to prevent four ports in an on/off-grid switching apparatus from being misconnected to an inverter, a backup load, a non-backup load, and a grid, thereby improving safety and reliability of the photovoltaic power generation system. Specifically, the on/off-grid switching apparatus includes a controller, a first switch, a second switch, and the four ports. The four ports include an inverter port, a backup load port, a non-backup load port, and a grid port. The controller is configured to: control the first switch and the second switch to be turned off, detect voltages of the four ports and frequencies of the voltages, and when the inverter outputs a voltage with a non-rated frequency, at least one phase voltage of another port other than the inverter port in the four ports is greater than or equal to a first voltage threshold, and a frequency of the at least one phase voltage of the another port is equal to the non-rated frequency, control the inverter and the on/off-grid switching apparatus to shut down.

## Description

### TECHNICAL FIELD

This application relates to the field of energy technologies, and in particular, to a photovoltaic power generation system, and a misconnection detection method and a phase sequence detection method therefor.

### BACKGROUND

A photovoltaic power generation system includes an inverter and an on/off-grid switching apparatus. The on/off-grid switching apparatus may also be referred to as a whole-house backup box. The on/off-grid switching apparatus includes four ports: an inverter port, a backup load port, a non-backup load port, and a grid (Grid) port. An input end of the inverter is configured to connect to an output end of a photovoltaic array or an energy storage apparatus, the inverter port is configured to connect to an output end of the inverter, the backup load port is configured to connect to a backup load, the non-backup load port is configured to connect to a non-backup load, and the grid port is configured to connect to a grid.

However, appearances of the four ports in the on/off-grid switching apparatus are similar. When being busy or careless, installation personnel may misconnect the four ports to the inverter, the backup load, the non-backup load, and the grid. As a result, the photovoltaic power generation system may fail to run normally, the backup load or the non-backup load may be damaged, and even personal safety of users may be threatened. Therefore, how to prevent the four ports from being misconnected to the inverter, the backup load, the non-backup load, and the grid, thereby improving safety and reliability of the photovoltaic power generation system, becomes an urgent problem to be resolved.

### SUMMARY

Embodiments of this application provide a photovoltaic power generation system, and a misconnection detection method and a phase sequence detection method therefor, to resolve a problem of how to prevent four ports in an on/off-grid switching apparatus from being misconnected to an inverter, a backup load, a non-backup load, and a grid, thereby improving safety and reliability of the photovoltaic power generation system.

To achieve the foregoing objective, the following technical solutions are used in embodiments of this application.

According to a first aspect of embodiments of this application, a photovoltaic power generation system is provided. The photovoltaic power generation system includes an inverter and an on/off-grid switching apparatus. An input end of the inverter is configured to connect to an output end of a photovoltaic array or an energy storage apparatus. The on/off-grid switching apparatus includes a controller, a first switch, a second switch, and four ports, the four ports include an inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to an output end of the inverter, the backup load port is configured to connect to a backup load, the non-backup load port is configured to connect to a non-backup load, the grid port is configured to connect to a grid, a voltage frequency of the grid is a rated frequency, the backup load is a device that needs to be powered by the inverter to continue working when the grid is powered off, and the non-backup load is a device that does not need to be powered by the inverter to continue working when the grid is powered off. The controller is configured to: control the first switch and the second switch to be turned off, detect voltages of the four ports and frequencies of the voltages, and when the inverter outputs a voltage with a non-rated frequency, at least one phase voltage of another port other than the inverter port in the four ports is greater than or equal to a first voltage threshold, and a frequency of the at least one phase voltage of the another port is equal to the non-rated frequency, determine that the another port other than the inverter port in the four ports is misconnected to the output end of the inverter, and control the inverter and the on/off-grid switching apparatus to shut down.

Based on this solution, when detecting that the at least one phase voltage of the another port other than the inverter port in the four ports is greater than or equal to the first voltage threshold, and the frequency of the at least one phase voltage of the another port is equal to the non-rated frequency, the controller may determine that the inverter port is not correctly connected to the output end of the inverter and the another port other than the inverter port in the four ports is misconnected to the output end of the inverter. The controller controls the inverter and the on/off-grid switching apparatus to shut down, so that the photovoltaic power generation system can be prevented from failing to run normally, damage to the backup load or the non-backup load can be avoided, and safety and reliability of the photovoltaic power generation system can be improved.

With reference to the first aspect, in an implementation, the controller is further configured to: when the inverter stops working, at least one phase voltage of the inverter port or the backup load port is greater than or equal to a second voltage threshold, and a frequency of the at least one phase voltage of the inverter port or the backup load port is equal to the rated frequency, determine that the inverter port or the backup load port is misconnected to the grid, and control the inverter and the on/off-grid switching apparatus to shut down.

Based on this solution, when detecting that the at least one phase voltage of the inverter port or the backup load port is greater than or equal to the second voltage threshold, and the frequency of the at least one phase voltage of the inverter port or the backup load port is equal to the rated frequency, the controller may determine that the grid port is not correctly connected to the grid and the inverter port or the backup load port is misconnected to the grid. The controller controls the inverter and the on/off-grid switching apparatus to shut down, so that the photovoltaic power generation system can be prevented from failing to run normally, the damage to the backup load or the non-backup load can be avoided, and the safety and the reliability of the photovoltaic power generation system can be improved.

With reference to the first aspect, in an implementation, the controller is further configured to: when three phase voltages of the grid port are all greater than or equal to the second voltage threshold, frequencies of the voltages are equal to the rated frequency, and a phase sequence of the three phase voltages of the grid port is abnormal, control the inverter and the on/off-grid switching apparatus to shut down, where that the phase sequence of the three phase voltages is abnormal means that the phase sequence of the three phase voltages is inconsistent with a positive sequence. The positive sequence means that in the three phase voltages, a phase of a phase A voltage leads a phase of a phase B voltage by 120°, the phase of the phase B voltage leads a phase of a phase C voltage by 120°, and the phase of the phase C voltage leads the phase of the phase A voltage by 120°.

Based on this solution, when determining that the grid port is connected to the grid, and the phase sequence of the three phase voltages of the grid port is abnormal, the controller controls the inverter and the on/off-grid switching apparatus to shut down, so that the photovoltaic power generation system can be prevented from failing to run normally, the damage to the backup load or the non-backup load can be avoided, and the safety and the reliability of the photovoltaic power generation system can be improved.

According to a second aspect of embodiments of this application, a photovoltaic power generation system is provided. The photovoltaic power generation system includes an inverter and an on/off-grid switching apparatus. An input end of the inverter is configured to connect to an output end of a photovoltaic array or an energy storage apparatus. The on/off-grid switching apparatus includes a controller, a first switch, a second switch, and four ports, the four ports include an inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to an output end of the inverter, the backup load port is configured to connect to a backup load, the non-backup load port is configured to connect to a non-backup load, the grid port is configured to connect to a grid, the backup load is a device that needs to be powered by the inverter to continue working when the grid is powered off, and the non-backup load is a device that does not need to be powered by the inverter to continue working when the grid is powered off. The controller is configured to: control the first switch and the second switch to be turned off, and control a voltage of a first phase output end of the inverter to be equal to a third voltage threshold, a voltage of a second phase output end to be equal to a fourth voltage threshold, and a voltage of a third phase output end to be equal to a rated voltage threshold, where the third voltage threshold is greater than the rated voltage threshold, and the fourth voltage threshold is less than the rated voltage threshold. The controller is further configured to: detect a voltage of the inverter port, and when a difference between a voltage of any phase port of the inverter port and a voltage of a corresponding phase output end of the inverter is greater than or equal to a fifth voltage threshold, determine that a phase sequence of three phase voltages of the inverter port is abnormal, and control the inverter and the on/off-grid switching apparatus to shut down. That the phase sequence of the three phase voltages of the inverter port is abnormal means that the phase sequence of the three phase voltages of the inverter port is inconsistent with a positive sequence.

Based on this solution, first, the controller controls three phase voltages output by the output end of the inverter to be disturbed, so that values of the three phase voltages are different. Then, when the difference between the voltage of any phase port of the inverter port and the voltage of the corresponding phase output end of the inverter is greater than or equal to the fifth voltage threshold, it is determined that three phase ports of the inverter port are not correctly connected to the three phase output ends of the inverter and the phase sequence of the three phase voltages of the inverter port is abnormal, and the inverter and the on/off-grid switching apparatus are controlled to shut down, so that the photovoltaic power generation system can be prevented from failing to run normally, the damage to the backup load or the non-backup load can be avoided, and the safety and the reliability of the photovoltaic power generation system can be improved.

With reference to the second aspect, in an implementation, the controller is further configured to: before controlling the voltage of the first phase output end to be equal to the third voltage threshold, the voltage of the second phase output end to be equal to the fourth voltage threshold, and the voltage of the third phase output end to be equal to the rated voltage threshold, control the three phase voltages of the output end of the inverter to be all equal to a sixth voltage threshold, where the sixth voltage threshold is greater than or less than the rated voltage threshold. The controller is further configured to: when a difference between each of the three phase voltages of the inverter port and the sixth voltage threshold is less than or equal to a seventh voltage threshold, control the voltage of the first phase output end to be equal to the third voltage threshold, the voltage of the second phase output end to be equal to the fourth voltage threshold, and the voltage of the third phase output end to be equal to the rated voltage threshold.

Based on this solution, when determining that the voltage of any phase output end of the inverter can be controlled, the controller controls the three phase voltages of the inverter, so that accuracy of detecting the phase sequence of the three phase voltages of the inverter port can be improved.

With reference to the second aspect, in an implementation, the controller is further configured to: control the inverter to stop working, control the second switch to be turned on, control two phase switches and a neutral wire switch in the first switch to be turned on, and when the difference between the voltage of any phase port of the inverter port and the voltage of the corresponding phase output end of the inverter is greater than or equal to the fifth voltage threshold, determine that the phase sequence of the three phase voltages of the inverter port is abnormal, and control the inverter and the on/off-grid switching apparatus to shut down.

Based on this solution, first, the controller controls the inverter to stop working, controls the second switch to be turned on, controls the two phase switches and a neutral wire switch in the first switch to be turned on, and when the difference between the voltage of any phase port of the inverter port and the voltage of the corresponding phase output end of the inverter is greater than or equal to the fifth voltage threshold, determines that the three phase ports of the inverter port are not correctly connected to the three phase output ends of the inverter and the phase sequence of the three phase voltages of the inverter port is abnormal, and controls the inverter and the on/off-grid switching apparatus to shut down, so that the photovoltaic power generation system can be prevented from failing to run normally, the damage to the backup load or the non-backup load can be avoided, and the safety and the reliability of the photovoltaic power generation system can be improved.

With reference to the second aspect, in an implementation, the controller is further configured to: when the difference between the voltage of any phase port of the inverter port and the voltage of the corresponding phase output end of the inverter is greater than or equal to the fifth voltage threshold within a preset time threshold, determine that the phase sequence of the three phase voltages of the inverter port is abnormal, and control the inverter and the on/off-grid switching apparatus to shut down.

Based on this solution, when accurately determining that the phase sequence of the three phase voltages of the inverter port is abnormal, the controller controls the inverter and the on/off-grid switching apparatus to shut down, thereby avoiding a misoperation, and improving the safety and the reliability of the photovoltaic power generation system.

According to a third aspect of embodiments of this application, a misconnection detection method for a photovoltaic power generation system is provided. The method is applied to the photovoltaic power generation system. The method includes: controlling a first switch and a second switch to be turned off, detecting voltages of four ports and frequencies of the voltages, and when an inverter outputs a voltage with a non-rated frequency, at least one phase voltage of another port other than an inverter port in the four ports is greater than or equal to a first voltage threshold, and a frequency of the at least one phase voltage of the another port is equal to the non-rated frequency, determining that the another port other than the inverter port in the four ports is misconnected to an output end of the inverter, and controlling the inverter and an on/off-grid switching apparatus to shut down. The photovoltaic power generation system includes the inverter and the on/off-grid switching apparatus, and an input end of the inverter is configured to connect to an output end of a photovoltaic array or an energy storage apparatus. The on/off-grid switching apparatus includes the first switch, the second switch, and the four ports, the four ports include the inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to the output end of the inverter, the backup load port is configured to connect to a backup load, the non-backup load port is configured to connect to a non-backup load, the grid port is configured to connect to a grid, a voltage frequency of the grid is a rated frequency, the backup load is a device that needs to be powered by the inverter to continue working when the grid is powered off, and the non-backup load is a device that does not need to be powered by the inverter to continue working when the grid is powered off.

With reference to the third aspect, in an implementation, the method further includes: when the inverter stops working, at least one phase voltage of the inverter port or the backup load port is greater than or equal to a second voltage threshold, and a frequency of the at least one phase voltage of the inverter port or the backup load port is equal to the rated frequency, determining that the inverter port or the backup load port is misconnected to the grid, and controlling the inverter and the on/off-grid switching apparatus to shut down.

With reference to the third aspect, in an implementation, the method further includes: when three phase voltages of the grid port are all greater than or equal to the second voltage threshold, frequencies of the voltages are equal to the rated frequency, and a phase sequence of the three phase voltages of the grid port is abnormal, controlling the inverter and the on/off-grid switching apparatus to shut down, where that the phase sequence of the three phase voltages is abnormal means that the phase sequence of the three phase voltages is inconsistent with a positive sequence.

According to a fourth aspect of embodiments of this application, a phase sequence detection method for a photovoltaic power generation system is provided. The method is applied to the photovoltaic power generation system. The method includes: controlling a first switch and a second switch to be turned off, and controlling a voltage of a first phase output end of an inverter to be equal to a third voltage threshold, a voltage of a second phase output end to be equal to a fourth voltage threshold, and a voltage of a third phase output end to be equal to a rated voltage threshold, where the third voltage threshold is greater than the rated voltage threshold, and the fourth voltage threshold is less than the rated voltage threshold; and detecting a voltage of an inverter port, and when a difference between a voltage of any phase port of the inverter port and a voltage of a corresponding phase output end of the inverter is greater than or equal to a fifth voltage threshold, determining that a phase sequence of three phase voltages of the inverter port is abnormal, and controlling the inverter and an on/off-grid switching apparatus to shut down. The on/off-grid switching apparatus includes the first switch, the second switch, and four ports, the four ports include the inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to an output end of the inverter, the backup load port is configured to connect to a backup load, the non-backup load port is configured to connect to a non-backup load, the grid port is configured to connect to a grid, the backup load is a device that needs to be powered by the inverter to continue working when the grid is powered off, and the non-backup load is a device that does not need to be powered by the inverter to continue working when the grid is powered off.

With reference to the fourth aspect, in an implementation, the method further includes: before controlling the voltage of the first phase output end to be equal to the third voltage threshold, the voltage of the second phase output end to be equal to the fourth voltage threshold, and the voltage of the third phase output end to be equal to the rated voltage threshold, controlling three phase voltages of the output end of the inverter to be all equal to a sixth voltage threshold, where the sixth voltage threshold is greater than or less than the rated voltage threshold; and when a difference between each of three phase voltages of the inverter port and the sixth voltage threshold is less than or equal to a seventh voltage threshold, controlling the voltage of the first phase output end to be equal to the third voltage threshold, the voltage of the second phase output end to be equal to the fourth voltage threshold, and the voltage of the third phase output end to be equal to the rated voltage threshold.

With reference to the fourth aspect, in an implementation, the method further includes: controlling the inverter to stop working, controlling the second switch to be turned on, controlling two phase switches and a neutral wire switch in the first switch to be turned on, and when the difference between the voltage of any phase port of the inverter port and the voltage of the corresponding phase output end of the inverter is greater than or equal to the fifth voltage threshold, determining that the phase sequence of the three phase voltages of the inverter port is abnormal, and controlling the inverter and the on/off-grid switching apparatus to shut down.

With reference to the fourth aspect, in an implementation, the method further includes: when the difference between the voltage of any phase port of the inverter port and the voltage of the corresponding phase output end of the inverter is greater than or equal to the fifth voltage threshold within a preset time threshold, determining that the phase sequence of the three phase voltages of the inverter port is abnormal, and controlling the inverter and the on/off-grid switching apparatus to shut down.

For descriptions of the third aspect of this application, refer to the detailed descriptions of the first aspect. For descriptions of the fourth aspect, refer to the descriptions of the second aspect. In addition, for beneficial effect of the third aspect, refer to beneficial effect analysis of the first aspect. For beneficial effect analysis of the fourth aspect, refer to beneficial effect analysis of the second aspect. Details are not described herein again.

### BRIEF DESCRIPTION OF DRAWINGS

FIG. 1 is a schematic of a circuit topology of a photovoltaic power generation system according to an embodiment of this application;
FIG. 2 is a schematic of a circuit topology of another photovoltaic power generation system according to an embodiment of this application;
FIG. 3 is a schematic flowchart of a misconnection detection method for a photovoltaic power generation system according to an embodiment of this application;
FIG. 4 is a schematic flowchart of a misconnection detection method for another photovoltaic power generation system according to an embodiment of this application;
FIG. 5 is a schematic flowchart of a misconnection detection method for another photovoltaic power generation system according to an embodiment of this application;
FIG. 6 is a schematic flowchart of a phase sequence detection method for a photovoltaic power generation system according to an embodiment of this application; and
FIG. 7 is a schematic flowchart of a phase sequence detection method for another photovoltaic power generation system according to an embodiment of this application.

### DESCRIPTION OF EMBODIMENTS

The making and use of embodiments are discussed in detail below. It should be understood, however, that many applicable inventive concepts provided in this application may be implemented in a plurality of specific environments. The discussed specific embodiments are merely used to describe specific manners to implement and use this specification and this technology, and do not limit the scope of this application.

Unless otherwise defined, all technical terms used herein have the same meaning as those commonly known to a person of ordinary skill in the art.

The circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not started), the circuit/component may also be referred to as being configured to perform the task. Circuits/components used in conjunction with the "configured to" phrase include hardware, for example, a circuit for performing an operation.

The following describes technical solutions in embodiments of this application with reference to the accompanying drawings in embodiments of this application. In this application, "at least one phase" means one phase or more phases, and "a plurality of" means two or more. The character "/" generally indicates an "or" relationship between the associated objects. In addition, in embodiments of this application, terms such as "first" and "second" do not limit a quantity or a sequence.

In this application, the term "example", "for example", or the like is used to give an example, an illustration, or a description. Any embodiment or design solution described as an "example" or "for example" in this application should not be explained as being more preferred or more advantageous than another embodiment or design solution. Exactly, use of the word like "example" or "for example" is intended to present a related concept in a specific manner.

Before embodiments of this application are described, the background of this application is first described.

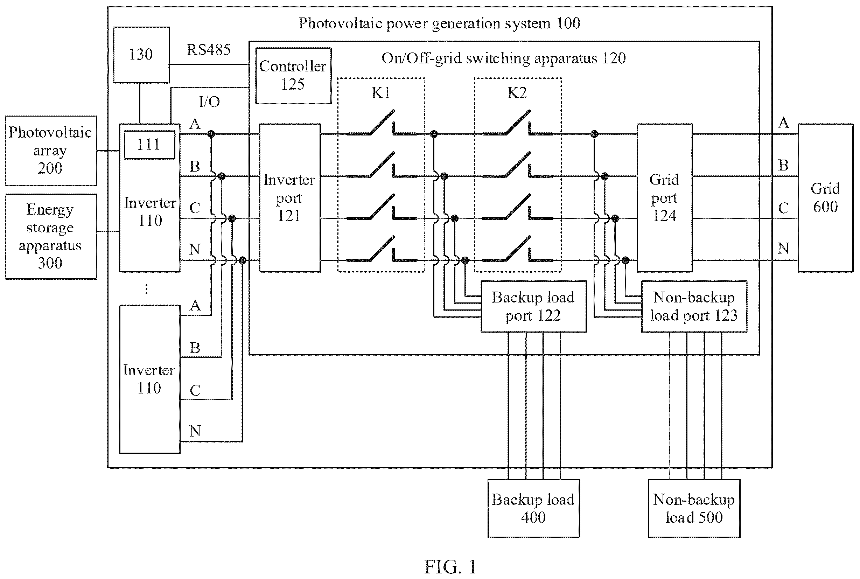

FIG. 1 is a schematic of a circuit topology of a photovoltaic power generation system 100 according to an embodiment of this application. The photovoltaic power generation system 100 includes an inverter 110 and an on/off-grid switching apparatus 120. The on/off-grid switching apparatus 120 includes a first switch K1, a second switch K2, and four ports. The four ports include an inverter port 121, a backup load port 122, a non-backup load port 123, and a grid port 124. Each port includes a phase A port, a phase B port, a phase C port, and a neutral wire (neutral wire, N) port. The first switch K1 includes a phase A switch, a phase B switch, a phase C switch, and a neutral wire switch. The second switch K2 includes a phase A switch, a phase B switch, a phase C switch, and a neutral wire switch. The first switch K1 and the second switch K2 are connected in series between the inverter port 121 and the grid port 124. A connection point of the first switch K1 and the second switch K2 is connected to the backup load port 122, and the non-backup load port 123 is connected to the grid port 124.

Refer to FIG. 1. An input end of the inverter 110 is configured to connect to an output end of a photovoltaic array 200 or an energy storage apparatus 300. The inverter port 121 is configured to connect to an output end of the inverter 110. The backup load port 122 is configured to connect to a backup load 400. The non-backup load port 123 is configured to connect to a non-backup load 500. The grid port 124 is configured to connect to a grid 600. The backup load 400 is a device that needs to be powered by the inverter 110 to continue working when the grid 600 is powered off. The non-backup load 500 is a device that does not need to be powered by the inverter 110 to continue working when the grid 600 is powered off. The photovoltaic array 200 is configured to convert solar energy into a direct current, the energy storage apparatus 300 is configured to output a direct current to the inverter 110, the inverter 110 is configured to convert the direct current into an alternating current, and the on/off-grid switching apparatus 120 is configured to perform on/off-grid switching.

However, appearances of the four ports in the on/off-grid switching apparatus 120 are similar. Although there are clear identifiers for distinguishing different ports, when installation personnel are busy or careless, the installation personnel may still misconnect the four ports to the inverter 110, the backup load 400, the non-backup load 500, and the grid 600. For example, the inverter port 121 is connected to the grid 600, or the backup load port 122 is connected to the output end of the inverter 110. As a result, the photovoltaic power generation system 100 may fail to run normally, the backup load 400 or the non-backup load 500 is damaged, or even personal safety of users is threatened. Therefore, how to prevent the four ports from being misconnected to the inverter 110, the backup load 400, the non-backup load 500, and the grid 600, thereby improving safety and reliability of the photovoltaic power generation system 100, has become an urgent problem to be resolved.

In an implementation, a wiring image in the photovoltaic power generation system 100 may be captured, and the wiring image may be compared with a standard wiring image, to determine whether the four ports in the on/off-grid switching apparatus 120 are misconnected. However, when sizes and colors of wiring terminals and cables are consistent, identification cannot be accurately performed, and safety and reliability of the photovoltaic power generation system 100 cannot be effectively improved.

In view of this, embodiments of this application provide a photovoltaic power generation system. By detecting voltages of the four ports in the on/off-grid switching apparatus 120 and frequencies of the voltages, it can be accurately determined whether the four ports in the on/off-grid switching apparatus 120 are misconnected, thereby improving the safety and the reliability of the photovoltaic power generation system 100.

In an implementation, a circuit topology of the photovoltaic power generation system provided in embodiments of this application may be the circuit topology of the photovoltaic power generation system 100 shown in FIG. 1. The photovoltaic power generation system 100 may further include a photovoltaic power generation system controller 130. The inverter 110 may further include a controller 111. The on/off-grid switching apparatus 120 may further include a controller 125. The photovoltaic power generation system controller 130 may communicate with and transmit data to the inverter 110 and the on/off-grid switching apparatus 120 through an RS485 communication cable. The controller 111 is configured to control a switching transistor in the inverter 110, and the controller 125 is configured to control the first switch K1 and the second switch K2. The on/off-grid switching apparatus 120 may further control the inverter 110 through an I/O communication cable.

In an implementation, still refer to FIG. 1. The photovoltaic power generation system 100 may include a plurality of inverters 110. Output ends of the plurality of inverters 110 are all configured to connect to the inverter port 121 in the on/off-grid switching apparatus 120.

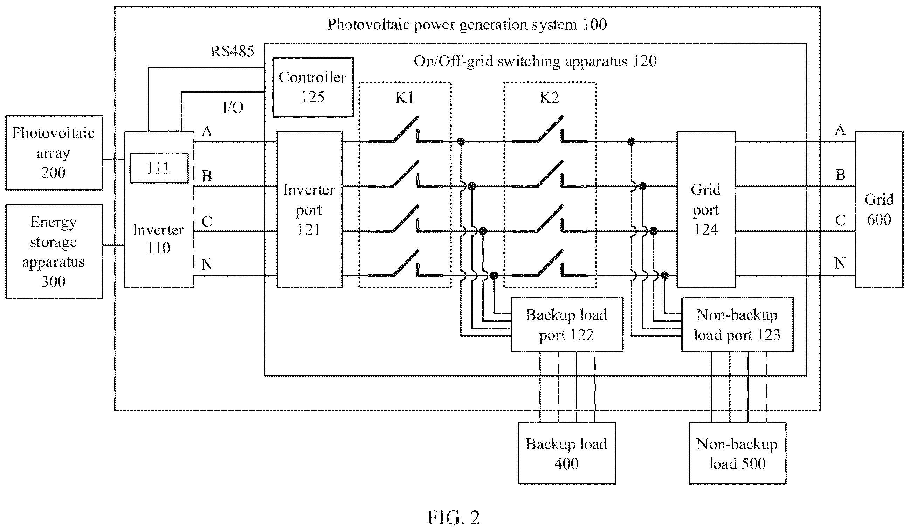

In an implementation, the photovoltaic power generation system controller 130 may be integrated with the controller 111 and then disposed in the inverter 110. Alternatively, FIG. 2 is a schematic of a circuit topology of another photovoltaic power generation system 100 according to an embodiment of this application. The photovoltaic power generation system controller 130 may be integrated with the controller 125 and then disposed in the on/off-grid switching apparatus 120. In this embodiment of this application, an example in which the photovoltaic power generation system controller 130 and the controller 125 are integrated into the controller 125 and then are disposed in the on/off-grid switching apparatus 120 is used for description.

In an implementation, refer to FIG. 1. In the on/off-grid switching apparatus 120, the backup load port 122 may be omitted, the inverter port 121 may also serve as the backup load port 122, and the inverter port 121 is further configured to connect to the backup load 400.

In an implementation, the inverter 110 in the photovoltaic power generation system 100 may alternatively be a single-phase inverter, and the on/off-grid switching apparatus 120 may alternatively be a single-phase on/off-grid switching apparatus. A port misconnection detection solution provided in this embodiment of this application may also be applied to the photovoltaic power generation system 100.

In an implementation, still refer to FIG. 2. A voltage frequency of the grid 600 is a rated frequency f. The controller 125 is configured to: control the first switch K1 and the second switch K2 to be turned off, detect voltages of the four ports and frequencies of the voltages, and when the inverter outputs a voltage with a non-rated frequency F, at least one phase voltage of another port other than the inverter port 121 in the four ports is greater than or equal to a first voltage threshold, and a frequency of the at least one phase voltage of the another port is equal to the non-rated frequency F, determine that the another port other than the inverter port 121 in the four ports is misconnected to the output end of the inverter 110, and control the inverter 110 and the on/off-grid switching apparatus 120 to shut down. Specific values of the non-rated frequency F and the first voltage threshold are not limited in embodiments of this application. For example, the non-rated frequency F may be 51 Hz or 61 Hz.

For example, the controller 125 is configured to: when a phase A voltage of the backup load port 122 is greater than the first voltage threshold, and a frequency of the phase A voltage of the backup load port 122 is equal to the non-rated frequency F, determine that the inverter port 121 is not correctly connected to the output end of the inverter 110 and the backup load port 122 is misconnected to the output end of the inverter 110, and the controller 125 controls the inverter 110 and the on/off-grid switching apparatus 120 to shut down.

In an implementation, the controller 125 includes a digital signal processing (digital signal processing, DSP) chip or a microcontroller unit (microcontroller unit, MCU), and the microcontroller unit may also be referred to as a single-chip microcomputer. This is not limited in embodiments of this application.

According to the photovoltaic power generation system 100 provided in embodiments of this application, when detecting that the at least one phase voltage of the another port other than the inverter port 121 in the four ports is greater than or equal to the first voltage threshold, and the frequency of the at least one phase voltage of the another port is equal to the non-rated frequency F, the controller 125 may determine that the inverter port 121 is not correctly connected to the output end of the inverter 110 and the another port other than the inverter port 121 in the four ports is misconnected to the output end of the inverter 110. The controller 125 controls the inverter 110 and the on/off-grid switching apparatus 120 to shut down, so that the photovoltaic power generation system 100 can be prevented from failing to run normally, damage to the backup load 400 or the non-backup load 500 can be avoided, and safety and reliability of the photovoltaic power generation system 100 can be improved.

In an implementation, the controller 125 is further configured to: when the inverter 110 stops working, at least one phase voltage of the inverter port 121 or the backup load port 122 is greater than or equal to a second voltage threshold, and a frequency of the at least one phase voltage of the inverter port 121 or the backup load port 122 is equal to the rated frequency f, determine that the inverter port 121 or the backup load port 122 is misconnected to the grid 600, and control the inverter 110 and the on/off-grid switching apparatus 120 to shut down. Specific values of the rated frequency f and the first voltage threshold are not limited in embodiments of this application. For example, the rated frequency f may be 50 Hz or 60 Hz.

For example, the controller 125 is configured to: when a phase B voltage of the inverter port 121 is greater than the second voltage threshold, and a frequency of the phase B voltage of the inverter port 121 is equal to the rated frequency f, determine that the grid port 124 is not correctly connected to the grid 600 and the inverter port 121 is misconnected to the grid 600, and the controller 125 controls the inverter 110 and the on/off-grid switching apparatus 120 to shut down.

According to the photovoltaic power generation system 100 provided in embodiments of this application, when detecting that the at least one phase voltage of the inverter port 121 or the backup load port 122 is greater than or equal to the second voltage threshold, and the frequency of the at least one phase voltage of the inverter port 121 or the backup load port 122 is equal to the rated frequency f, the controller 125 may determine that the grid port 124 is not correctly connected to the grid 600, and the inverter port 121 or the backup load port 122 is misconnected to the grid 600. The controller 125 controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

In an implementation, still refer to FIG. 2. When the four ports in the on/off-grid switching apparatus 120 are not misconnected, the installation personnel may misconnect the phase A port, the phase B port, the phase C port, and the neutral wire port of the grid port 124 to a phase A wire, a phase B wire, a phase C wire, and a neutral wire of the grid 600 when being busy or careless. For example, the installation personnel may connect the phase A port to the phase B wire, connect the phase B port to the phase A wire, connect the phase C port to the phase C wire, and connect the neutral wire port to the neutral wire. As a result, a phase sequence of three phase voltages of the grid port 124 is abnormal, the photovoltaic power generation system 100 may fail to run normally, the backup load 400 or the non-backup load 500 is damaged, and even personal safety of users is threatened. That the phase sequence of the three phase voltages is abnormal means that the phase sequence of the three phase voltages is inconsistent with a positive sequence. The positive sequence means that in the three phase voltages, a phase of a phase A voltage leads a phase of a phase B voltage by 120°, the phase of the phase B voltage leads a phase of a phase C voltage by 120°, and the phase of the phase C voltage leads the phase of the phase A voltage by 120°.

Still refer to FIG. 2. The controller 125 is further configured to: when the three phase voltages of the grid port 124 are all greater than or equal to the second voltage threshold, frequencies of the voltages are equal to the rated frequency f, and it is determined that the grid port 124 is connected to the grid 600 and the phase sequence of the three phase voltages of the grid port 124 is abnormal, control the inverter 110 and the on/off-grid switching apparatus 120 to shut down.

In an implementation, the controller 125 may determine, based on the three phase voltages of the grid port 124, whether the phase sequence of the three phase voltages of the grid port 124 is abnormal. For a specific process, refer to the conventional technology. Details are not described herein in embodiments of this application.

According to the photovoltaic power generation system 100 provided in embodiments of this application, when determining that the grid port 124 is connected to the grid 600, and the phase sequence of the three phase voltages of the grid port 124 is abnormal, the controller 125 controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

In an implementation, still refer to FIG. 2. When the four ports in the on/off-grid switching apparatus 120 are not misconnected, the installation personnel may misconnect the phase A port, the phase B port, the phase C port, and the neutral wire port of the inverter port 121 to a phase A output end, a phase B output end, a phase C output end, and a neutral wire output end of the output end of the inverter 110 when being busy or careless. As a result, a phase sequence of three phase voltages of the inverter port 121 is abnormal, the photovoltaic power generation system 100 may fail to run normally, the backup load 400 or the non-backup load 500 is damaged, and even personal safety of users is threatened. That the phase sequence of the three phase voltages of the inverter port 121 is abnormal means that the phase sequence of the three phase voltages of the inverter port is inconsistent with the positive sequence.

In a first implementation, the controller 125 is further configured to: control the first switch K1 and the second switch K2 to be turned off, and control a voltage of a first phase output end of the inverter 110 to be equal to a third voltage threshold, a voltage of a second phase output end to be equal to a fourth voltage threshold, and a voltage of a third phase output end to be equal to a rated voltage threshold, where the third voltage threshold is greater than the rated voltage threshold, and the fourth voltage threshold is less than the rated voltage threshold. Specific values of the third voltage threshold, the fourth voltage threshold, and the rated voltage threshold are not limited in embodiments of this application.

For example, the controller 125 is further configured to control a voltage of the phase A output end of the inverter 110 to be equal to the third voltage threshold, a voltage of the phase B output end to be equal to the fourth voltage threshold, and a voltage of the phase C output end to be equal to the rated voltage threshold.

In an implementation, that the controller 125 controls a voltage of any phase output end of the inverter 110 to be equal to a voltage threshold includes: The voltage of any phase output end is equal to the voltage threshold, or the voltage of any phase output end approaches the voltage threshold. This is not limited in embodiments of this application.

The controller 125 is further configured to: detect a voltage of the inverter port 121, and when a difference between a voltage of any phase port of the inverter port 121 and a voltage of a corresponding phase output end of the inverter 110 is greater than or equal to a fifth voltage threshold, determine that a phase sequence of three phase voltages of the inverter port 121 is abnormal, and control the inverter 110 and the on/off-grid switching apparatus 120 to shut down. A specific value of the fifth voltage threshold is not limited in embodiments of this application.

For example, the controller 125 is further configured to: when a difference between a voltage of the phase A port of the inverter port 121 and a voltage of the corresponding phase A output end of the inverter 110 is greater than or equal to the fifth voltage threshold, determine that the phase A port of the inverter port 121 is not correctly connected to the phase A output end of the inverter 110 and the phase sequence of the three phase voltages of the inverter port 121 is abnormal, and control the inverter 110 and the on/off-grid switching apparatus 120 to shut down.

In an implementation, the controller 125 is further configured to: when the difference between the voltage of any phase port of the inverter port 121 and the voltage of the corresponding phase output end of the inverter 110 is greater than or equal to the fifth voltage threshold within a preset time threshold, determine that the phase sequence of the three phase voltages of the inverter port 121 is abnormal, and control the inverter 110 and the on/off-grid switching apparatus 120 to shut down. A specific value of the preset time threshold is not limited in embodiments of this application. In this way, when accurately determining that the phase sequence of the three phase voltages of the inverter port 121 is abnormal, the controller 125 may control the inverter 110 and the on/off-grid switching apparatus 120 to shut down, thereby avoiding a misoperation, and improving the safety and the reliability of the photovoltaic power generation system 100.

In an implementation, the controller 125 is further configured to: before controlling the voltage of the first phase output end to be equal to the third voltage threshold, the voltage of the second phase output end to be equal to the fourth voltage threshold, and the voltage of the third phase output end to be equal to the rated voltage threshold, control three phase voltages of the output end of the inverter 110 to be all equal to a sixth voltage threshold, where the sixth voltage threshold is greater than or less than the rated voltage threshold. A specific value of the sixth voltage threshold is not limited in embodiments of this application.

The controller 125 is further configured to: when a difference between each of three phase voltages of the inverter port 121 and the sixth voltage threshold is less than or equal to a seventh voltage threshold, control the voltage of the first phase output end to be equal to the third voltage threshold, the voltage of the second phase output end to be equal to the fourth voltage threshold, and the voltage of the third phase output end to be equal to the rated voltage threshold. A specific value of the seventh voltage threshold is not limited in embodiments of this application. In this way, when determining that the voltage of any phase output end of the inverter 110 can be controlled, the controller 125 may control the three phase voltages of the inverter 110, so that accuracy of detecting the phase sequence of the three phase voltages of the inverter port 121 can be improved.

According to the photovoltaic power generation system 100 provided in embodiments of this application, first, the controller 125 controls three phase voltages output by the output end of the inverter 110 to be disturbed, so that values of the three phase voltages are different. Then, when the difference between the voltage of any phase port of the inverter port 121 and the voltage of the corresponding phase output end of the inverter 110 is greater than or equal to the fifth voltage threshold, it is determined that three phase ports of the inverter port 121 are not correctly connected to the three phase output ends of the inverter 110 and the phase sequence of the three phase voltages of the inverter port 121 is abnormal, and the inverter 110 and the on/off-grid switching apparatus 120 are controlled to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

In a second implementation, still refer to FIG. 2. The controller 125 is further configured to: control the inverter 110 to stop working, control the second switch K2 to be turned on, control two phase switches and a neutral wire switch in the first switch K1 to be turned on, and when the difference between the voltage of any phase port of the inverter port 121 and the voltage of the corresponding phase output end of the inverter 110 is greater than or equal to the fifth voltage threshold, determine that the phase sequence of the three phase voltages of the inverter port 121 is abnormal, and control the inverter 110 and the on/off-grid switching apparatus 120 to shut down.

For example, the controller 125 is further configured to: control the inverter 110 to stop working, control the second switch K2 to be turned on, control the phase A switch, the phase B switch, and the neutral wire switch in the first switch K1 to be turned on, and when a difference between a voltage of the phase A port of the inverter port 121 and a voltage of the corresponding phase A output end of the inverter 110 is greater than the fifth voltage threshold, determine that the phase A port of the inverter port 121 is not correctly connected to the phase A output end of the inverter 110 and the phase sequence of the three phase voltages of the inverter port 121 is abnormal, and control the inverter 110 and the on/off-grid switching apparatus 120 to shut down.

In an implementation, the controller 125 is further configured to: when the difference between the voltage of any phase port of the inverter port 121 and the voltage of the corresponding phase output end of the inverter 110 is greater than or equal to the fifth voltage threshold within a preset time threshold, determine that the phase sequence of the three phase voltages of the inverter port 121 is abnormal, and control the inverter 110 and the on/off-grid switching apparatus 120 to shut down. A specific value of the preset time threshold is not limited in embodiments of this application. In this way, when accurately determining that the phase sequence of the three phase voltages of the inverter port 121 is abnormal, the controller 125 may control the inverter 110 and the on/off-grid switching apparatus 120 to shut down, thereby avoiding a misoperation, and improving the safety and the reliability of the photovoltaic power generation system 100.

In an implementation, the controller 125 communicates with the inverter 110 to obtain voltages of phase output ends of the inverter 110. Before detecting the phase sequence of the three phase voltages of the inverter port 121, the controller 125 may perform a communication test with the inverter 110, to determine whether communication with the inverter 110 is abnormal. When communication with the inverter 110 is normal, the controller 125 detects the phase sequence of the three phase voltages of the inverter port 121 by using the first implementation or the second implementation, thereby avoiding impact of a communication exception on a detection result, and improving the safety and the reliability of the photovoltaic power generation system 100.

According to the photovoltaic power generation system 100 provided in embodiments of this application, first, the controller 125 controls the inverter 110 to stop working, controls the second switch K2 to be turned on, controls the two phase switches and a neutral wire switch in the first switch K1 to be turned on, and when the difference between the voltage of any phase port of the inverter port 121 and the voltage of the corresponding phase output end of the inverter 110 is greater than or equal to the fifth voltage threshold, determines that the three phase ports of the inverter port 121 are not correctly connected to the three phase output ends of the inverter 110 and the phase sequence of the three phase voltages of the inverter port 121 is abnormal, and controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

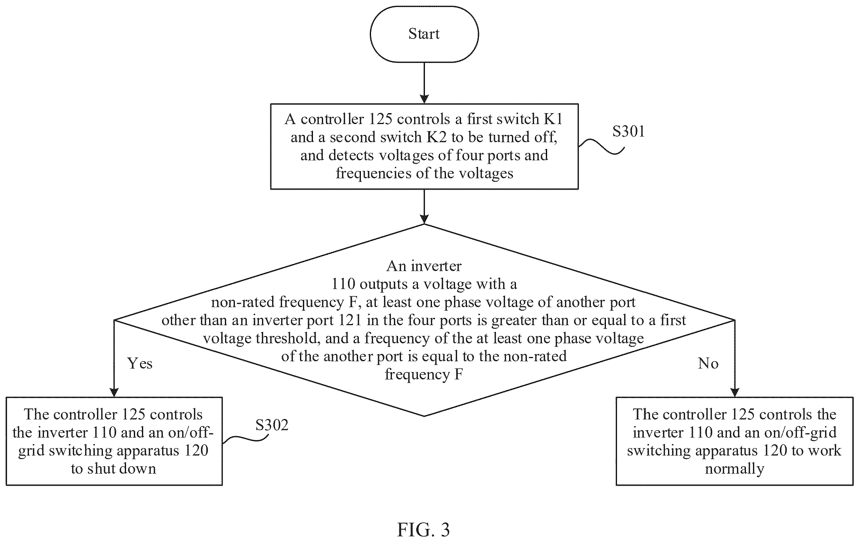

In view of this, as shown in FIG. 3, embodiments of this application further provide a misconnection detection method for a photovoltaic power generation system, applied to the photovoltaic power generation system 100. The method includes step S301 and step S302.

S301: The controller 125 controls the first switch K1 and the second switch K2 to be turned off, and detects voltages of the four ports in the on/off-grid switching apparatus 120 and frequencies of the voltages.

S302: When the inverter 110 outputs a voltage with a non-rated frequency F, at least one phase voltage of another port other than the inverter port 121 in the four ports is greater than or equal to a first voltage threshold, and a frequency of the at least one phase voltage of the another port is equal to the non-rated frequency F, the controller 125 determines that the another port other than the inverter port 121 in the four ports is misconnected to the output end of the inverter 110, and control the inverter 110 and the on/off-grid switching apparatus 120 to shut down. Specific values of the non-rated frequency F and the first voltage threshold are not limited in embodiments of this application.

In an implementation, when the foregoing condition in S302 is not met, and it is determined that the inverter 110 is not misconnected to the another port other than the inverter port 121, the controller 125 may control the inverter 110 and the on/off-grid switching apparatus 120 to work normally.

According to the misconnection detection method for the photovoltaic power generation system 100 provided in embodiments of this application, when detecting that the at least one phase voltage of the another port other than the inverter port 121 in the four ports is greater than or equal to the first voltage threshold, and the frequency of the voltage is equal to the non-rated frequency F, the controller 125 may determine that the inverter port 121 is not correctly connected to the output end of the inverter 110 and the another port other than the inverter port 121 in the four ports is misconnected to the output end of the inverter 110. The controller 125 controls the inverter 110 and the on/off-grid switching apparatus 120 to shut down, so that the photovoltaic power generation system 100 can be prevented from failing to run normally, damage to the backup load 400 or the non-backup load 500 can be avoided, and safety and reliability of the photovoltaic power generation system 100 can be improved.

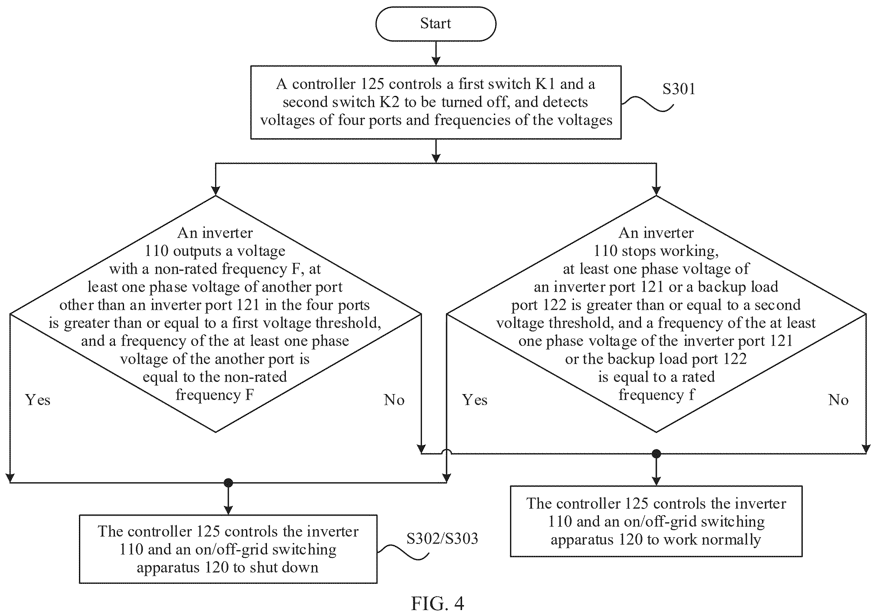

In an implementation, as shown in FIG. 4, the misconnection detection method for the photovoltaic power generation system 100 provided in embodiments of this application further includes step S303. When step S303 is performed, step S303 and step S302 may be performed in any sequence.

S303: When the inverter 110 stops working, at least one phase voltage of the inverter port 121 or the backup load port 122 is greater than or equal to a second voltage threshold, and a frequency of the at least one phase voltage of the inverter port 121 or the backup load port 122 is equal to a rated frequency f, determine that the inverter port 121 or the backup load port 122 is misconnected to the grid 600, and control the inverter 110 and the on/off-grid switching apparatus 120 to shut down. A voltage frequency of the grid 600 is the rated frequency f. Specific values of the rated frequency f and the first voltage threshold are not limited in embodiments of this application.

In an implementation, when the foregoing condition in S303 is not met, and it is determined that the grid 600 is not misconnected to the inverter port 121 or the backup load port 122, the controller 125 may control the inverter 110 and the on/off-grid switching apparatus 120 to work normally.

According to the misconnection detection method for the photovoltaic power generation system 100 provided in embodiments of this application, when detecting that the at least one phase voltage of the inverter port 121 or the backup load port 122 is greater than or equal to the second voltage threshold, and the frequency of the voltage is equal to the rated frequency f, the controller 125 may determine that the grid port 124 is not correctly connected to the grid 600, and the inverter port 121 or the backup load port 122 is misconnected to the grid 600. The controller 125 controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

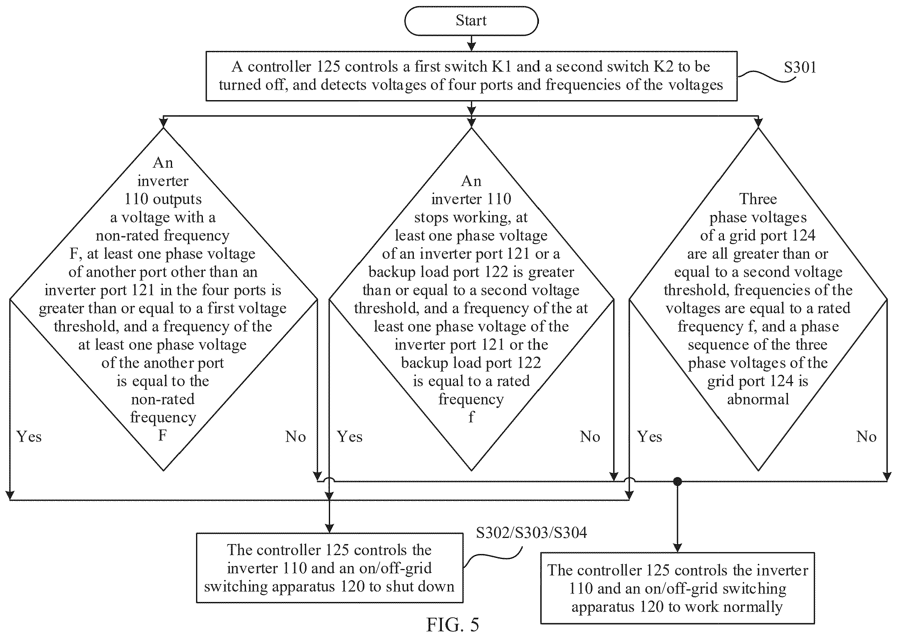

In an implementation, as shown in FIG. 5, the misconnection detection method for the photovoltaic power generation system 100 provided in embodiments of this application further includes step S304. When step S304 is performed, step S304, step S302, and step S303 may be performed in any sequence.

S304: When three phase voltages of the grid port 124 are all greater than or equal to the second voltage threshold, frequencies of the voltages are equal to the rated frequency f, and it is determined that the grid port 124 is connected to the grid 600 and a phase sequence of the three phase voltages of the grid port 124 is abnormal, the controller 125 controls the inverter 110 and the on/off-grid switching apparatus 120 to shut down. That the phase sequence of the three phase voltages is abnormal means that the phase sequence of the three phase voltages is inconsistent with a positive sequence.

In an implementation, when the foregoing condition in S304 is not met, and it is determined that the phase sequence of the three phase voltages of the grid port 124 is normal, the controller 125 may control the inverter 110 and the on/off-grid switching apparatus 120 to work normally.

According to the misconnection detection method for the photovoltaic power generation system 100 provided in embodiments of this application, when determining that the grid port 124 is connected to the grid 600, and the phase sequence of the three phase voltages of the grid port 124 is abnormal, the controller 125 controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

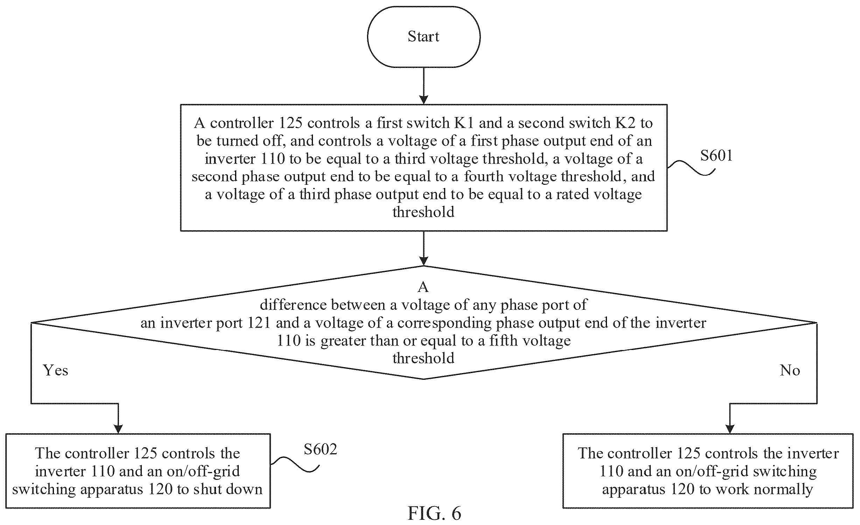

As shown in FIG. 6, embodiments of this application further provide a phase sequence detection method for the photovoltaic power generation system 100, applied to the photovoltaic power generation system 100. The method includes step S601 and step S602.

S601: The controller 125 controls the first switch K1 and the second switch K2 to be turned off, and controls a voltage of a first phase output end of the inverter 110 to be equal to a third voltage threshold, a voltage of a second phase output end to be equal to a fourth voltage threshold, and a voltage of a third phase output end to be equal to a rated voltage threshold. The third voltage threshold is greater than the rated voltage threshold, and the fourth voltage threshold is less than the rated voltage threshold. Specific values of the third voltage threshold, the fourth voltage threshold, and the rated voltage threshold are not limited in embodiments of this application.

S602: The controller 125 detects a voltage of the inverter port 121, and when a difference between a voltage of any phase port of the inverter port 121 and a voltage of a corresponding phase output end of the inverter 110 is greater than or equal to a fifth voltage threshold, determines that a phase sequence of three phase voltages of the inverter port 121 is abnormal, and controls the inverter 110 and the on/off-grid switching apparatus 120 to shut down. A specific value of the fifth voltage threshold is not limited in embodiments of this application.

In an implementation, when the foregoing condition in S602 is not met, and it is determined that the three phase ports of the inverter port 121 are correctly connected to the three phase output ports of the inverter 110 and the phase sequence of the three phase voltages of the inverter port 121 is normal, the controller 125 may control the inverter 110 and the on/off-grid switching apparatus 120 to work normally.

In an implementation, when the difference between the voltage of any phase port of the inverter port 121 and the voltage of the corresponding phase output end of the inverter 110 is greater than or equal to the fifth voltage threshold within a preset time threshold, the controller 125 determines that the phase sequence of the three phase voltages of the inverter port 121 is abnormal, and controls the inverter 110 and the on/off-grid switching apparatus 120 to shut down. A specific value of the preset time threshold is not limited in embodiments of this application. In this way, when accurately determining that the phase sequence of the three phase voltages of the inverter port 121 is abnormal, the controller 125 may control the inverter 110 and the on/off-grid switching apparatus 120 to shut down, thereby avoiding a misoperation, and improving the safety and the reliability of the photovoltaic power generation system 100.

According to the phase sequence detection method for the photovoltaic power generation system 100 provided in embodiments of this application, first, the controller 125 controls three phase voltages output by the output end of the inverter 110 to be disturbed, so that values of the three phase voltages are different. Then, when the difference between the voltage of any phase port of the inverter port 121 and the voltage of the corresponding phase output end of the inverter 110 is greater than or equal to the fifth voltage threshold, it is determined that three phase ports of the inverter port 121 are not correctly connected to the three phase output ends of the inverter 110 and the phase sequence of the three phase voltages of the inverter port 121 is abnormal, and the inverter 110 and the on/off-grid switching apparatus 120 are controlled to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

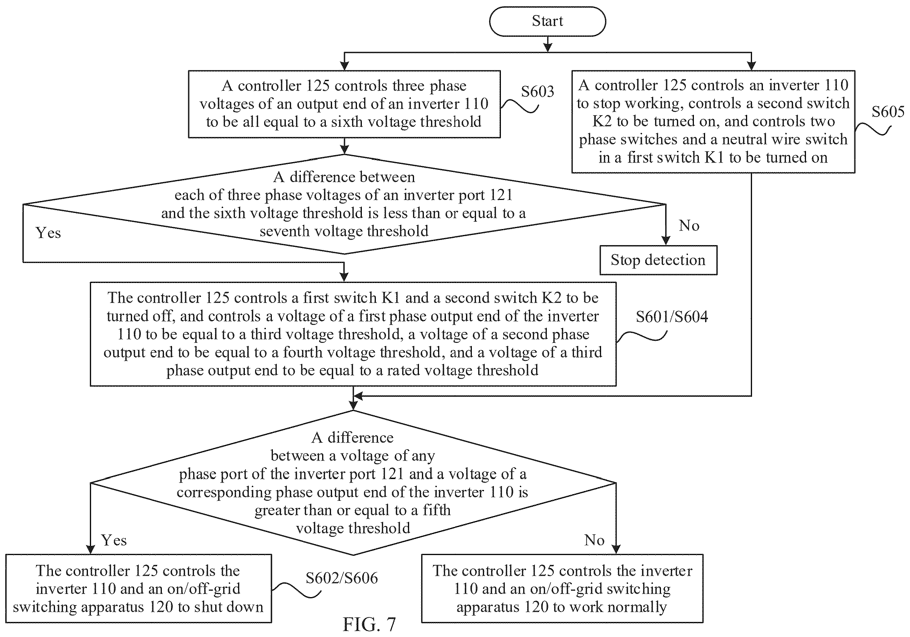

In an implementation, as shown in FIG. 7, the phase sequence detection method for the photovoltaic power generation system 100 provided in embodiments of this application further includes step S603 and step S604. Step S603 is performed before step S601, and step S604 and step S601 are simultaneously performed.

S603: Before controlling the voltage of the first phase output end to be equal to the third voltage threshold, the voltage of the second phase output end to be equal to the fourth voltage threshold, and the voltage of the third phase output end to be equal to the rated voltage threshold, the controller 125 controls three phase voltages of the output end of the inverter 110 to be all equal to a sixth voltage threshold, where the sixth voltage threshold is greater than or less than the rated voltage threshold. A specific value of the sixth voltage threshold is not limited in embodiments of this application.

S604: When a difference between each of three phase voltages of the inverter port 121 and the sixth voltage threshold is less than or equal to a seventh voltage threshold, the controller 125 controls the voltage of the first phase output end to be equal to the third voltage threshold, the voltage of the second phase output end to be equal to the fourth voltage threshold, and the voltage of the third phase output end to be equal to the rated voltage threshold. A specific value of the seventh voltage threshold is not limited in embodiments of this application.

In an implementation, when the foregoing condition in S604 is not met, and it is determined that the voltages of the three phase output ends of the inverter 110 cannot be normally controlled, the controller 125 may stop detecting the phase sequence of the three phase voltages of the inverter port 121.

According to the phase sequence detection method for the photovoltaic power generation system 100 provided in embodiments of this application, when determining that the voltage of any phase output end of the inverter 110 can be controlled, the controller 125 controls the three phase voltages of the inverter 110, so that accuracy of detecting the phase sequence of the three phase voltages of the inverter port 121 can be improved.

In an implementation, as shown in FIG. 7, the phase sequence detection method for the photovoltaic power generation system 100 provided in embodiments of this application further includes step S605 and step S606. When step S605 and step S606 are performed, either step S605 and step S606 or step S601 to step S604 may be performed.

S605: The controller 125 controls the inverter 110 to stop working, controls the second switch K2 to be turned on, and controls two phase switches and a neutral wire switch in the first switch K1 to be turned on.

S606: When a difference between a voltage of any phase port of the inverter port 121 and a voltage of a corresponding phase output end of the inverter 110 is greater than or equal to a fifth voltage threshold, the controller 125 determines that a phase sequence of three phase voltages of the inverter port 121 is abnormal, and controls the inverter 110 and an on/off-grid switching apparatus 120 to shut down.

In an implementation, when the foregoing condition in S606 is not met, and it is determined that the three phase ports of the inverter port 121 are correctly connected to the three phase output ports of the inverter 110 and the phase sequence of the three phase voltages of the inverter port 121 is normal, the controller 125 may control the inverter 110 and the on/off-grid switching apparatus 120 to work normally.

In an implementation, when the difference between the voltage of any phase port of the inverter port 121 and the voltage of the corresponding phase output end of the inverter 110 is greater than or equal to the fifth voltage threshold within a preset time threshold, the controller 125 determines that the phase sequence of the three phase voltages of the inverter port 121 is abnormal, and controls the inverter 110 and the on/off-grid switching apparatus 120 to shut down. A specific value of the preset time threshold is not limited in embodiments of this application. In this way, when accurately determining that the phase sequence of the three phase voltages of the inverter port 121 is abnormal, the controller 125 may control the inverter 110 and the on/off-grid switching apparatus 120 to shut down, thereby avoiding a misoperation, and improving the safety and the reliability of the photovoltaic power generation system 100.

According to the phase sequence detection method for the photovoltaic power generation system 100 provided in embodiments of this application, first, the controller 125 controls the inverter 110 to stop working, controls the second switch K2 to be turned on, controls the two phase switches and a neutral wire switch in the first switch K1 to be turned on, and when the difference between the voltage of any phase port of the inverter port 121 and the voltage of the corresponding phase output end of the inverter 110 is greater than or equal to the fifth voltage threshold, determines that the three phase ports of the inverter port 121 are not correctly connected to the three phase output ends of the inverter 110 and the phase sequence of the three phase voltages of the inverter port 121 is abnormal, and controls the inverter 110 and the on/off-grid switching apparatus 120 to shut down, so that the photovoltaic power generation system 100 can be prevented from failing to run normally, the damage to the backup load 400 or the non-backup load 500 can be avoided, and the safety and the reliability of the photovoltaic power generation system 100 can be improved.

The foregoing detailed descriptions of the photovoltaic power generation system 100 and beneficial effect analysis may be correspondingly cited in the misconnection detection method and the phase sequence detection method of the photovoltaic power generation system. Details are not described herein again in embodiments of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A photovoltaic power generation system, wherein the photovoltaic power generation system comprises an inverter and an on/off-grid switching apparatus, and an input end of the inverter is configured to connect to an output end of a photovoltaic array or an energy storage apparatus;
the on/off-grid switching apparatus comprises a controller, a first switch, a second switch, and four ports, the four ports comprise an inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to an output end of the inverter, the backup load port is configured to connect to a backup load, the non-backup load port is configured to connect to a non-backup load, the grid port is configured to connect to a grid, a voltage frequency of the grid is a rated frequency, and the backup load is a device that needs to be powered by the inverter to continue working when the grid is powered off; and
the controller is configured to: control the first switch and the second switch to be turned off, detect voltages of the four ports and frequencies of the voltages, and when the inverter outputs a voltage with a non-rated frequency, at least one phase voltage of another port other than the inverter port in the four ports is greater than or equal to a first voltage threshold, and a frequency of the at least one phase voltage of the another port is equal to the non-rated frequency, control the inverter and the on/off-grid switching apparatus to shut down; or,
the controller is configured to: control the first switch and the second switch to be turned off, and control a voltage of a first phase output end of the inverter to be equal to a third voltage threshold, a voltage of a second phase output end to be equal to a fourth voltage threshold, and a voltage of a third phase output end to be equal to a rated voltage threshold, wherein the third voltage threshold is greater than the rated voltage threshold, and the fourth voltage threshold is less than the rated voltage threshold; and detect a voltage of the inverter port, and when a difference between a voltage of any phase port of the inverter port and a voltage of a corresponding phase output end of the inverter is greater than or equal to a fifth voltage threshold, control the inverter and the on/off-grid switching apparatus to shut down.

2. The photovoltaic power generation system according to claim 1, wherein
the controller is further configured to: when the inverter stops working, at least one phase voltage of the inverter port or the backup load port is greater than or equal to a second voltage threshold, and a frequency of the at least one phase voltage of the inverter port or the backup load port is equal to the rated frequency, control the inverter and the on/off-grid switching apparatus to shut down.

3. The photovoltaic power generation system according to claim 1 or 2, wherein
the controller is further configured to: when three phase voltages of the grid port are all greater than or equal to the second voltage threshold, frequencies of the voltages are equal to the rated frequency, and a phase sequence of the three phase voltages of the grid port is abnormal, control the inverter and the on/off-grid switching apparatus to shut down, wherein that the phase sequence of the three phase voltages is abnormal means that the phase sequence of the three phase voltages is inconsistent with a positive sequence.

4. The photovoltaic power generation system according to claim 1, wherein
the controller is further configured to: before controlling the voltage of the first phase output end to be equal to the third voltage threshold, the voltage of the second phase output end to be equal to the fourth voltage threshold, and the voltage of the third phase output end to be equal to the rated voltage threshold, control three phase voltages of the output end of the inverter to be all equal to a sixth voltage threshold, wherein the sixth voltage threshold is greater than or less than the rated voltage threshold; and
the controller is further configured to: when a difference between each of three phase voltages of the inverter port and the sixth voltage threshold is less than or equal to a seventh voltage threshold, control the voltage of the first phase output end to be equal to the third voltage threshold, the voltage of the second phase output end to be equal to the fourth voltage threshold, and the voltage of the third phase output end to be equal to the rated voltage threshold.

5. The photovoltaic power generation system according to claim 1 or 4, wherein
the controller is further configured to: control the inverter to stop working, control the second switch to be turned on, control two phase switches and a neutral wire switch in the first switch to be turned on, and when the difference between the voltage of any phase port of the inverter port and the voltage of the corresponding phase output end of the inverter is greater than or equal to the fifth voltage threshold, control the inverter and the on/off-grid switching apparatus to shut down.

6. The photovoltaic power generation system according to claim 1or5, wherein
the controller is further configured to: when the difference between the voltage of any phase port of the inverter port and the voltage of the corresponding phase output end of the inverter is greater than or equal to the fifth voltage threshold within a preset time threshold, control the inverter and the on/off-grid switching apparatus to shut down.

7. A misconnection detection method for a photovoltaic power generation system, applied to the photovoltaic power generation system, the photovoltaic power generation system comprises the inverter and the on/off-grid switching apparatus, and an input end of the inverter is configured to connect to an output end of a photovoltaic array or an energy storage apparatus; and
the on/off-grid switching apparatus comprises the first switch, the second switch, and the four ports, the four ports comprise the inverter port, a backup load port, a non-backup load port, and a grid port, the first switch and the second switch are connected in series between the inverter port and the grid port, a connection point of the first switch and the second switch is connected to the backup load port, the non-backup load port is connected to the grid port, the inverter port is configured to connect to an output end of the inverter, the backup load port is configured to connect to a backup load, the non-backup load port is configured to connect to a non-backup load, the grid port is configured to connect to a grid, a voltage frequency of the grid is a rated frequency, and the backup load is a device that needs to be powered by the inverter to continue working when the grid is powered off;
wherein the method comprises:
controlling a first switch and a second switch to be turned off, detecting voltages of four ports and frequencies of the voltages, and when an inverter outputs a voltage with a non-rated frequency, at least one phase voltage of another port other than an inverter port in the four ports is greater than or equal to a first voltage threshold, and a frequency of the at least one phase voltage of the another port is equal to the non-rated frequency, controlling the inverter and an on/off-grid switching apparatus to shut down; or,
wherein the method comprises:
controlling a first switch and a second switch to be turned off, and controlling a voltage of a first phase output end of an inverter to be equal to a third voltage threshold, a voltage of a second phase output end to be equal to a fourth voltage threshold, and a voltage of a third phase output end to be equal to a rated voltage threshold, wherein the third voltage threshold is greater than the rated voltage threshold, and the fourth voltage threshold is less than the rated voltage threshold; and
detecting a voltage of an inverter port, and when a difference between a voltage of any phase port of the inverter port and a voltage of a corresponding phase output end of the inverter is greater than or equal to a fifth voltage threshold, controlling the inverter and an on/off-grid switching apparatus to shut down.

8. The method according to claim 7, wherein the method further comprises:
when the inverter stops working, at least one phase voltage of the inverter port or the backup load port is greater than or equal to a second voltage threshold, and a frequency of the at least one phase voltage of the inverter port or the backup load port is equal to the rated frequency, controlling the inverter and the on/off-grid switching apparatus to shut down.

9. The method according to claim 7 or8, wherein the method further comprises:
when three phase voltages of the grid port are all greater than or equal to the second voltage threshold, frequencies of the voltages are equal to the rated frequency, and a phase sequence of the three phase voltages of the grid port is abnormal, controlling the inverter and the on/off-grid switching apparatus to shut down, wherein that the phase sequence of the three phase voltages is abnormal means that the phase sequence of the three phase voltages is inconsistent with a positive sequence.

10. The method according to claim 7, wherein the method further comprises:
before controlling the voltage of the first phase output end to be equal to the third voltage threshold, the voltage of the second phase output end to be equal to the fourth voltage threshold, and the voltage of the third phase output end to be equal to the rated voltage threshold, controlling three phase voltages of the output end of the inverter to be all equal to a sixth voltage threshold, wherein the sixth voltage threshold is greater than or less than the rated voltage threshold; and
when a difference between each of three phase voltages of the inverter port and the sixth voltage threshold is less than or equal to a seventh voltage threshold, controlling the voltage of the first phase output end to be equal to the third voltage threshold, the voltage of the second phase output end to be equal to the fourth voltage threshold, and the voltage of the third phase output end to be equal to the rated voltage threshold.

11. The method according to claim 7 or 10, wherein the method further comprises:
controlling the inverter to stop working, controlling the second switch to be turned on, controlling two phase switches and a neutral wire switch in the first switch to be turned on, and when the difference between the voltage of any phase port of the inverter port and the voltage of the corresponding phase output end of the inverter is greater than or equal to the fifth voltage threshold, controlling the inverter and the on/off-grid switching apparatus to shut down.

12. The method according to claim 7 or 11, wherein the method further comprises:
when the difference between the voltage of any phase port of the inverter port and the voltage of the corresponding phase output end of the inverter is greater than or equal to the fifth voltage threshold within a preset time threshold, controlling the inverter and the on/off-grid switching apparatus to shut down.
